(19) Europäisches Patentamt
European Patent Office
Office européen des brevets

(11) Publication number: 0 193 643
A2

(12) # EUROPEAN PATENT APPLICATION

(21) Application number: 85113451.0

(22) Date of filing: 23.10.85

(51) Int. Cl.⁴: **C 08 G 59/26**, C 08 G 59/68, C 08 J 3/28, C 08 K 5/54

(30) Priority: 26.02.85 JP 35345/85
28.02.85 JP 37460/85

(43) Date of publication of application: 10.09.86 Bulletin 86/37

(84) Designated Contracting States: CH DE FR GB LI NL

(71) Applicant: Kabushiki Kaisha Toshiba, 72, Horikawa-cho Saiwai-ku, Kawasaki-shi Kanagawa-ken 210 (JP)

(72) Inventor: Kohara, Teiji, c/o Kabushiki Kaisha Toshiba 72, Horikawacho, Saiwai-ku Kawasaki-shi Kanagawa-ken (JP)
Inventor: Hayase, Shuzi, c/o Kabushiki Kaisha Toshiba 72, Horikawacho, Saiwai-ku Kawasaki-shi Kanagawa-ken (JP)
Inventor: Suzuki, Shuichi, c/o Kabushiki Kaisha Toshiba 72, Horikawacho, Saiwai-ku Kawasaki-shi Kanagawa-ken (JP)
Inventor: Wada, Moriyasu, c/o Kabushiki Kaisha Toshiba 72, Horikawacho, Saiwai-ku Kawasaki-shi Kanagawa-ken (JP)

(74) Representative: Lehn, Werner, Dipl.-Ing. et al, Hoffmann, Eitle & Partner Patentanwälte
Arabellastrasse 4 (Sternhaus), D-8000 München 81 (DE)

(54) **Curable resin composition.**

(57) A curable resin composition comprising, (a) at least one of partially acrylated and methacrylated epoxy resins; (b) a sensitizer which can initiate at least one of acryloyl group or methacryloyl group by photoirradiation; and (c) a curing catalyst comprising an organic metal compound and an organic silicon compound. The curable resin composition of this invention can be cured by photoirradiation and heating, and the cured product obtained has excellent electrical characteristics, adhesiveness, humidity resistance and solder heat resistance, and therefore it can be expected to be useful for electrical insulating materials, paints, materials for solder resist, etc.

EP 0 193 643 A2

Curable resin composition

## BACKGROUND OF THE INVENTION

This invention relates to a curable resin composition. More particularly, the present invention relates to a curable resin composition which can be cured by photoirradiation and heating to give a cured product having excellent electrical characteristics, solder heat resistance, humidity resistance, adhesiveness, etc., which is very useful, for example, for solder resist of printed wiring plate, etc.

In recent years, in the field of electrical or electronic instruments, as the wiring circuit is made higher in density or highly integrated, the electrical insulating materials, paints, resist materials have been strongly desired to have excellent electrical characteristics, particularly excellent electrical characteristics at higher temperatures, as well as good adhesiveness with the materials to be coated and good heat resistance of the coated film on the material surface.

In the prior art, in printed wiring plates, it has been known to use an imagewise protective film for protection

of the circuit and for prevention of solder bridge during soldering of parts (hereinafter called "solder resist").

As the resin for solder resist, epoxy type thermosetting resins, acrylate type and/or methacrylate type photocurble resins, etc. have been employed. Among them, epoxy type thermosetting resins are excellent in electrical characteristics, solder heat resistance, humidity resistance, adhesiveness, etc. but they have the drawback that, because of the printing method such as screen printing employed for formation of the image of solder resist, it is inferior in dimensional precision and therefore not applicable for a printed wiring plate with high density minute pattern. On the other hand, acrylate type and/or methacrylate type photocurable resins are excellent in workability, since curing can be accomplished within a short time, and it is possible to employ, as the image forming method, the above printing method and the photographic method, namely, in which the photocurable resin laminated on the printed wiring plate is exposed through a nega mask, then developed by removing the unexposed portion with a solvent to form an image corresponding to the nega mask. The photographic method, which is excellent in dimensional precision of the image, is advantageous in production of printed wiring plates with high density minute patterns. However, acrylate type and/or methacrylate type photocurable resins cannot necessarily be satisfactory with respect to electrical characteristics, solder heat resistance, humidity resistance, etc.

As an improvement of the problems of epoxy type thermosetting resins or acrylate type and/or methacrylate type photocurable resins as described above, for example, Japanese Unexamined Patent Publication No. 62636/1983 discloses a composition for solder resist in which an

epoxy resin having phososensitive groups capable of forming images by the photographic method is used. However, since this resin is an oligomer having photosensitive groups introduced into the main chain of the molecule, it is limited in solubility in solvents, and not necessarily excellent in workability. For example, there are involved the problems such that it is difficultly soluble in a nonflammable developing solvent for general purpose preferred for ensuring safety during production of printed wiring plates, such as 1,1,1-trichloroethane, trichloroethylene, tetrachloroethane, etc., or that it will take a long time for development due to poor solubility. Thus, this composition cannot be appreciated as satisfactory.

Various studies and developments have been progressed in order to obtain resin compositions having good characteristics responding to such demands. Consequently, as such resin compositions, there have been known those comprising partially acrylated and/or methacrylated [hereinafter abbreviated as (meth)acrylated] epoxy resins obtained by addition reaction of acrylic acid and/or methacrylic acid [hereinafter abbreviated as (meth)acrylic acid] to an epoxy resin at a ratio not more than equivalent to the epoxy groups in said epoxy resin. Here, the partially (meth)acrylated epoxy resin was greatly useful as the resin having both the photocurability through acryloyl group and/or methacryloy groups [hereinafter abbreviated as (meth)acryloyl groups] and the properties of electrical characteristics, heat resistance and adhesiveness imparted by curing of the epoxy groups. Also, the partially (meth)acrylated epoxy resin, because of having (meth)acryloyl group and epoxy group in one molecule, is different in properties from the resin composition comprising a mixture of an acrylate resin

and/or a methacrylate resin with an epoxy resin, and had more excellent photocurability. The partially (meth)acrylated resin, while having itself good characteristics as mentioned above, suffered from marked lowering in storage stability of the resin or electrical characteristics of the cured product, caused by the residual catalyst in the (meth)acrylated epoxy resin formed, because a quaternary ammonium salt or a tertiary amine is used as the catalyst in order to progress smoothly the addition reaction during production of the resin. Also, difficulties have been encountered in removal of the residual catalyst, and cumbersome washing steps or separation steps are required in most cases to be disadvantageous also industrial applications. For this reason, even after the catalyst removing operation, a small amount of the catalyst will frequently remain, whereby there is involved the drawback that satisfactory electrical characteristics could not necessarily be obtained. Further, as the method for curing the partially (meth)acrylated epoxy resin, there have been generally employed the method in which a photopolymerization initiator, a sensitizer or a thermal polymerization initiator is used alone or in combination for polymerization of (meth)acryloyl groups; and the method in which a curing agent or curing catalyst such as an amine type compound, an acid anhydride type compound, Lewis acid type compound, etc. is used for curing of epoxy groups. However, when the resin compositions of the prior art are used as insulating materials, encapsulating resin materials or resist materials for electronic or electrical instrument parts, they involved the drawbacks of having not necessarily satisfactory electrical characteristics or good workability.

## SUMMARY OF THE INVENTION

An object of this invention is to cancel the drawbacks as described above, and particularly to provide a curable resin composition which can be cured by photoirradiation and heating and is useful in, for example, solder resist for a printed wiring plate with excellent electrical characteristics, solder heating resistance, adhesiveness and developing characteristic, etc.

The curable composition of this invention comprises:

(a) at least one of partially acrylated and methacrylated epoxy resins;

(b) a sensitizer which can initiate the polymerization of at least one of acryloyl group or methacryloyl group by photoirradiation;

(c) a curing catalyst comprising an organic metal compound and an organic silicon compound.

In a preferred embodiments, the curable composition may further comprises;

(d) a compound having at least one group selected from the group consisting of acryloyl group, methacryloyl group and epoxy group, with proviso that component (a) is excluded.

## PREFERRED EMBODIMENTS OF THE INVENTION

The partially (meth)acrylated epoxy resin (a) may be any one of those known generally as partially (meth)acrylated epoxy resins. Such partially (meth)acrylated epoxy resins may be produced, for example, according to the following procedure. In the presence of a tertiary amine such as dimethylbenzyl amine or a quaternary ammonium salt such as chlorinated trimethylbenzylammonium, an epoxy resin is allowed to react with (meth)acrylic acid at a ratio of (meth)acrylic acid not more than

equivalent to the epoxy groups in the epoxy resin at a temperature of 100 to 110 °C for about less than 10 hours.

Among these components (a), there may be included a resin obtained by, for example, reacting an epoxy resin with (meth)acrylic acid at a proportion of (meth)acrylic acid not more than equivalent to the epoxy groups in the epoxy resin, preferably at an equivalent ratio (latter/former) of 0.1 to 0.9, more preferably at an equivalent ratio (latter/former) of 0.3 to 0.8. Here, in the case of an equivalent ratio less than 0.1, the photocurability of the resultant partially (meth)acrylated epoxy resin will be inferior, while at an equivalent ratio over 0.9, the cured product of the resin obtained will be inferior in adhesion to the substrate, electrical characteristics, solder heat resistance, etc.

Among these components (a), particularly when employing the curable composition of this invention for solder resist of the printed wiring plate, it is preferred to use a resin obtained by the addition reaction between an epoxy resin having two epoxy groups in the molecular with an average molecular weight of 150 to 1500 and (meth)acrylic acid as described above. If the average molecular weight in the epoxy resin is less than 150, a resin with excellent heat resistance can be obtained with difficulty. On the other hand, if the average molecular weight exceeds 1500, solubility in a solvent, for example, a halo-containing nonflammable solvent such as 1,1,1-trichloroethane. is inferior. Preferably, the average molecular weight is 200 to 1200. Also, for the component (a), a resin obtained by allowing an epoxy resin to react with (meth)acrylic acid in the presence of an organic metal compound or an organic phosphorus compound is preferred. This is because the cured product

of the curable composition of this invention can have excellent electrical characteristics.

The epoxy resin to be used for preparation of the partially (meth)acrylated epoxy resin is not particularly limited, but inclusive of any of those known generally as epoxy resins. Typical examples may include, for example, bisphenol A type epoxy resin, bisphenol F type epoxy resin, phenol novolac type epoxy resin, cresol novolac type epoxy resin, hydrogenated bisphenol A type epoxy resin, glycidylether type epoxy resins obtained by the reaction between phenols or alcohols and epichlorohydrin, glycidylester type epoxy resins obtained by the reaction between aromatic or aliphatic carboxylic acids and epichlorohydrin. On the other hand, as organic metal compounds, complexes of Al, Ga, Sn, Zr, Zn, Cu, Fe, Co, Ni, Mn, Cr, V, Pt, Mo, Pd, etc. having β-diketone, β-ketoester, salicylaldehyde derivative, etc. as ligand. Typical examples of ligand may include acetyl acetone, benzoylacetone, trifluoroacetylacetone, hexafluoroacetylacetone, 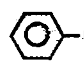$-CH_2COCH_2COCH_3$, $CH_3COCH(CH_3)COCH_3$, $(CH_3)_2CH-COCH_2COCH(CH_3)_2$, $CH_3COCH_2COOC_2H_5$, $CH_3COCH_2COOC_3H_7$, $CH_3COCH_2COOCH_3$, salicylaldehyde, 2-acetylphenol, 2-hydroxybenzophenone, etc. Specific examples of these complexes may include trisacetylacetonatoaluminum, tris(trifluoroacetylacetonato)aluminum, trisbenzoylacetonatoaluminum, trisethylacetoacetatoaluminum, trissalicylaldehydatoaluminum, tris(2-acetylphenolato)aluminum, gallium(III)acetylacetonate, tin(II)acetylacetonate, zirconium(IV)acetylacetonate, zinc(II)acetylacetonate, copper(II)acetylacetonate, iron(II)acetylacetonate, cobalt(III)acetylacetonate, nickel(II)acetylacetonate, manganese(III)acetylacetonate, chromium(III)acetylacetonate, vanadium oxide acetylacetonate, platinum(II)acetylacetonate, molybdenum oxide acetylacetonate, palladium-(II)acetylacetonate, etc. Among them, an aluminum complex

may preferably be employed, since excellent effects of electrical characteristics can be brougth about. Further, as the organic phosphorus compound, Lewis bases such as tertiary phosphine, phosphorous ester, etc. may effectively be used. Among them, tertiary phosphines acting as weakly acidic bases may be employed, including, for example, triphenylphosphine, tri-(p-tolyl)phosphine, tri-(p-methoxyphenyl)phosphine, tricyclohexylphosphine, 1,2-bis(diphenylphosphino)ethane, 1,3-bis(diphenylphosphino)propane, 1,4-bis(diphenylphosphino)butane and the like.

Here, the amount of the organic metal compound to be employed may be generally 5 % by weight or less, preferably 2 % by weight or less, based on the epoxy resin. This is because the residual catalyst in the partially (meth)acrylated epoxy resin obtained will lower the electrical characteristics of the composition of this invention, if the amount employed is over 5 % by weight. On the other hand, the amount of the organic phosphorus compound to be employed may be generally 0.5 % by weight or less, preferably 0.05 % by weight or less, based on the epoxy resin. This is because, the residual catalyst in the partially (meth)acrylated epoxy resin obtained will lower electrical characteristics, thermal curability of the composition of the present, and may also cause coloration, if the amount employed is over 0.5 % by weight.

The sensitizer (b) to be used in the curable resin composition of this invention initiates polymerization of (meth)acryloyl groups by photoirradiation, and may be any sensitizer employed in photopolymerization in general, including, for example, biacetyl, acetophenone, benzophenone, benzyl, benzoin, benzoin isobutyl ether, benzyl dimethyl ketal, benzoyl peroxide, 1-hydroxycyclo-

hexylphenyl ketone, (1-hydroxy-1-methylethyl)phenyl ketone, p-isopropyl-α-hydroxyisobutylphenone and so on.

The amount of the component (b) employed may be generally 0.5 to 10 % by weight, preferably 1 to 5 % by weight, based on the total amount of the components (a) to (c), or the total amount of the componetns (a) to (d) when the composition contains the component (d). When the amount employed is less than 0.5 % by weight, the composition of the preent invention is inferior in photocurability, while at a level over 10 % by weight, the cured product will be inferior in electrical characteristics, heat resistance, humidity resistance, solvent resistance, etc.

The curing catalyst (c) to be used in the composition of this invention comprises an organic metal compound and an organic silicon compound, and polymerization of epoxy groups is initiated by using both in combination.

The organic metal compounds may include organic metal compounds of Ti, V, Cr, Mn, Fe, Co, Ni, Cu, Zn, Al, Zr, etc. Among them, organic aluminum compounds are preferred. Organic aluminum compounds may effectively those having alkoxy groups, aryloxy groups, acyloxy groups, β-diketonato groups, β-ketoesterato groups bonded to aluminum atom. Among them, those having β-diketonato groups and/or β-ketoesterato groups bonded to aluminum atom are preferred. Specific examples of such organic aluminum compounds may include trismethoxyaluminum, trisethoxyaluminum, trisisopropoxyaluminum, trisphenoxyaluminum, tris-p-methylphenoxyaluminum, isopropoxydiethoxyaluminum, trisbutoxyaluminum, trisacetoxyaluminum, trisstearatoaluminum, trisbutylato-aluminum, trispropionatoaluminum, trisisopropionato-aluminum, trisacetylacetonatoaluminum, tristrifluoro-acetylacetonatoaluminum, trishexafluoroacetylacetonato-

aluminum, trisethylacetoacetatoaluminum, trissalicylaldehydatoaluminum, trisdiethylmalonatoaluminum, trispropylacetoacetatoaluminum, trisbutylacetoacetatoaluminum, trisbenzoylacetonatoaluminum, tris-o-acetylphenolatoaluminum, tris-o-propionylphenolatoaluminum, etc. These may be used either singly or as a mixed system of two or more compounds. The amount of these compounds employed may be generally 0.1 to 5 % by weight, preferably 0.5 to 3 % by weight, based on the total amount of the components (a) to (c) or the total amount of the components (a) to (d) when the composition of this invention containg the component (d). If the amount employed is less than 0.1 % by weight, no satisfactory curing characteristics can be obtained, while electrical characteristics and adhesiveness will be lowered at a level in excess of 5 % by weight. Next, as the organic silicon compound, a compound capable of forming silanol groups by heating and/or photoirradiation may effectively be used. For example, compounds having at least one selected from the group consisting of alkoxysilyl groups, aryloxysilyl groups, peroxysilyl groups and α-ketosilyl groups may be employed. An organic silicon compound having at least one of alkoxysilyl groups and aryloxysilyl groups can be used together with the above organic metal compound to exhibit the curability of the epoxy groups by heating. Also, an organic silicon compound having at least one of peroxysilyl groups and α-ketosilyl groups can be used together with the above organic metal compound to exhibit curability of epoxy groups by photoirradiation and/or heating. Among these organic silicon compounds, specific examples of organic silicon compounds having at least one of alkoxysilyl groups and aryloxysilyl groups may include triphenylmethoxy silane, triphenylethoxy silane, triphenylpropoxy silane, triphenylbenzyloxy silane, triphenylphenoxy silane, diphenyltolylmethoxy silane,

diphenyltolylethoxy silane, diphenyldimethoxy silane, diphenyldiethoxy silane, diphenyldipropoxy silane, dimethylphenylmetoxy silane, dimethylphenylethoxy silane, dimethyldimethoxy silane, dimethyldiethoxy silane, dimethyldiphenoxy silane and the like. Specific examples of the compounds having peroxysilyl groups may include tert-butylperoxytriphenyl silane, di-(tert-butylperoxy)-diphenylsilane, 1,1-dimethylpropylperoxytriphenyl silane, di(1,1-dimethylpropylperoxy)diphenylsilane, 1-methyl-ethylperoxytriphenylsilane, di(1-methylethylperoxy)-diphenyl silane, tert-butylperoxymethyldiphenyl silane, tert-butylperoxydimethylphenyl silane and the like. Specific examples of the compounds having α-ketosilyl groups may include benzoyltriphenyl silane, benzoyl-methyldiphenylsilane, benzoyldimethylphenyl silane, acetyltriphenyl silane, propionyltriphenyl silane, acetylmethyldiphenyl silane, benzoyltrimethyl silane, benzoylmethoxydiphenyl silane and the like. These organic silicon compounds may be used either singly or as a mixed system of two or more compounds. The amount of these compounds employed may be generally 0.1 to 10 % by weight, preferably 1 to 5 % by weight, based on the total amount of the components (a) to (c) or the total amount of the components (a) to (d) when the comosition of this invention contains the component (d). If the amount employed is less than 0.1 % by weight, no satisfactory curing characteristics can be obtained, while there may sometimes be caused problems such as increased cost or lowering in adhesiveness, etc. at a level in excess of 10 % by weight.

The respective proportions to be formulated of the organic metal compound and the organic silicon compound of the curing catalyst (c) to be used in this invention have been described above, but it is preferred to employ the whole component (c) in an amount of 0.5 to 10 % by

weight based on the total amount of the components (a) to (c) or the total amount of the components (a) to (d) when containing the component (d), when the composition of this invention is to be used for the solder resist of a printed wiring plate.

When the composition of this invention is to be employed for the solder resist of a printed wiring plate, it is preferred to add, in addition to the above components, a compound (d) having at least one group selected from acryloyl group, methacryloyl group and epoxy group, and the compound (d) is added for the purpose of controlling viscosity, improving photocurability, imparting flexibility of the composition according to this invention. Such compounds may include, for example, acrylic acid ester, methacrylic acid esters, acrylated resins, methacrylated resins, epoxy type reactive diluents, epoxy resins, etc. Specific examples of these compounds may include methyl acrylate, ethyl acrylate, propyl acrylate, 2-hydroxyethyl arylate, 2-hydroxypropylacrylate, 2-hydroxy-3-phenoxypropylacrylate, tetrahydrofurfurylacrylate, methyl methacrylate, ethyl methacrylate, propyl methacrylate, 2-hydroxyethyl methacrylate, 2-hydroxypropyl methacrylate, 2-hydroxy-3-phenoxypropyl methacrylate, tetrahydrofurfuryl methacrylate, methoxydiethyleneglycol methacrylate, methoxydiethyleneglycol acrylate, methoxytetraethyleneglycol methacrylate, methoxytetraethyleneglycol acrylate, phenoxyethyloxyethyl methacrylate, phenoxyethyloxyethyl acrylate, phenoxypolyethyleneglycol methacrylate, phenoxypolyethyleneglycol acrylate, 3-chloro-2-hydroxypropyl methacrylate, 3-chloro-2-hydroxypropyl acrylate, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, polyethyleneglycol

diacrylate, polyethyleneglycol dimethacrylate, propyleneglycol diacrylate, propyleneglycol dimethacrylate, dipropyleneglycol diacrylate, dipropyleneglycol dimethacrylate, tripropyleneglycol diacrylate, tripropyleneglycol dimethacrylate, polypropyleneglycol diacrylate, polypropyleneglycol dimethacrylate, 1,4-butyleneglycol diacrylate, 1,4-butyleneglycol dimethacrylate, 1,6-hexanediol diacrylate, 1,6-hexanediol dimethacrylate, neopentylglycol diacrylate, neopentylglycol dimethacrylate, 2-hydroxy-1,3-diacryloxy-propane, 2-hydroxy-1,3-dimetha-cryloxy-propane, 2,2-bis[4-(acryloxydiethoxy)phenyl]-propane, 2,2-bis[4-(methacryloxydiethoxy)phenyl]propane, 2,2-bis[4-(acryloxypolyethoxy)phenyl]propane, 2,2-bis[4-(methacryloxypolyethoxy)phenyl]propane, trimethylolpropane triacrylate, trimethylolpropane trimethacrylate, tetramethylolmethane, triacrylate, tetramethylolmethane trimethacrylate, tetramethylolmethane tetraacrylate, tetramethylolmethane tetramethacrylate, polyester diacrylate, polyester dimethacrylate, dipentaerythrytol hexaacrylate, dipentaerythrytol hexamethacrylate, tri(acryloxyethoxy)-cyanurate, tri(methacryloxyethoxy)cyanurate, tri(acryloxydiethoxy)cyanurate, tri(methacryloxydi-ethoxy)cyanurate, tri(1,3-diacryloxy-2-propoxy)cyanurate, tri(1,3-dimethacryloxy-2-propoxy)cyanurate, di(2-acryloxyethyl)phthalate, di(2-methacryloxyethyl)-phthalate, di(2-acryloxyethyl)isophthalate, di(2-methacryloxyethyl)isophthalate, di(2-acryoxyethyl)-terephthalate, di(2-methacryloxyethyl)terephthalate, glycidyl acrylate, glycidyl methacrylate, methyl glycidyl ether, ethyl glycidyl ether, propyl glycidyl ether, butyl glycidyl ether, phenyl glycidyl ether, epichlorohydrin, glycidyl acetate, glycidyl propionate, glycidyl benzoate, ethyleneglycol diglycidyl ether, diethyleneglycol diglycidyl ether, propyleneglycol diglycidyl ether,

dipropyleneglycol diglycidyl ether, triethyleneglycol diglycidyl ether, polyethyleneglycol diglycidyl ether, tripropyleneglycol diglycidyl ether, polypropyleneglycol diglycidyl ether, 1,3-propyleneglycol diglycidyl ether, 1,4-butyleneglycol diglycidyl ether, 1,6-hexanediol diglycidyl ether, neopentylglycol diglycidyl ether, methoxyethyleneglycol glycidyl ether, methoxydiethyleneglycol glycidyl ether, methoxytetraethyleneglycol glycidyl ether, phenoxyethylglycidyl ether, styrene oxide, cyclohexane oxide, di(4-glycidyloxyphenyl)methane, 2,2-bis(4'-glycidyloxyphenyl)propane, 4-vinylcyclohexene-diepoxide, bisphenol F type epoxy resin, bisphenol A type epoxy resin, hydrogenated bisphenol A type epoxy resin, phenol novolac type epoxy resin, cresol novolac type epoxy resin, alicyclic epoxy resin and so on.

The ratio of the component (a) to (d) as described above may be generally 40 : 60 to 95 : 5 in terms of weight ratio (a/d), preferably 50 : 50 to 90 : 10. When the ratio of the component (a) employed exceeds the above range, the viscosity of the composition is so high that workability may be lowered or the flexibility of the cured product may be lowered. On the other hand, when it does not satisfy the above range, it is difficult to satisfy at the same time excellent photocurability, electrical characteristics, heat resistance and humidity resistance of the cured product. The proportion of the total amount of the components (a) and (d) in the total amount of the components (a) to (d) of this invention may generally be 80 to 99 % by weight, preferably 85 to 98.5 % by weight.

The composition of this invention may also incorporate solvents, polymeric compounds, antioxidants, flexibility imparting agents, flame retardants, dyes, pigments, leveling agents, defoaming agents, inorganic fillers,

etc., if desired. Particularly, when the composition of this invention is to be used for solder resist, the above components should desirably be formulated. The amounts to be formulated may be 300 parts by weight or less, preferably 200 parts by weight or less, based on the total amount of the components (a) to (d). If these additives exceed 300 parts by weight, it is not preferred because photocurability and/or heat curability of the curable resin composition will be inferior. Particularly, when the composition of the present inventon is employed for solder resist of printed wiring plate, the amount of the above components formulated should be 100 parts or less, preferably 70 parts by weight or less.

The curable resin composition of this invention can be produced readily by mixing and sirring predetermined amounts of the above components in a conventional manner.

The curable resin comosition of this invention can be cured by photoirradition and heating to exhibit excellent characteristics, namely electrical characteristics, adhesiveness, mechanical toughness and het resistance. The wavelength of light advantageous for curing of the curable resin composition of this invention may generally be within the range of from 180 to 700 nm, preferably from 180 to 400 nm. Also, when the curble resin composition is cured by heating, it is preferred to perform curing at a temperature from 50 to 220 °C, preferably from 100 to 200 °C. The method of curing and the order are not particularly limited, but there may generally be employed the method in which heating is effected subsequent to photoirradiation or the method in which photoirradiation and heating are simultaneously conducted.

As the method for forming the image of solder resist with the curable resin composition of this invention, either screen printing method or photographic method may be applicable. When photographic method is employed, after exposure, developing can be carried out by use of a nonflammable halogenated hydrocarbon type solvent such as 1,1,1-trichloroethane, trichloroethylene, tetrachloroethane, followed by heating curing to impart characteristics such as electrical characteristics, solder heat resistance, humidity resistance, adhesiveness, etc. as demanded for solder resist.

This invention is described in more detail by referring to Examples and Comparative examples, in which "parts" indicate all "parts by weight".

Example 1

A curable resin composition was prepared by formulating 100 parts of a partially acrylated epoxy resin (epoxy equivalent: 810, free acid: 0.15 meq/g, epoxy group/acryloyl group: 1/3) obtained by allowing 500 parts of an epoxy resin, Epikote 828 (trade name, produced by Yuka-Shell Epoxy Co., bisphenol A type epoxy resin, average molecular weight: 380, epoxy equivalent: 190) to react with 142 parts of acrylic acid with the use of 13 parts of trisacetylacetonatoaluminum as the catalyst and 2.6 parts of p-methoxyphenol as the thermal polymerization inhibitor at 110 °C for 12 hours, 30 parts of 1,4-dioxane, 4 parts of (1-hydroxy-1-methylethyl)phenyl ketone, one part of tris(ethylacetoacetato)aluminum and 3 parts of tert-butylperoxytriphenyl silane. The curable resin composition was applied uniformly by a bar coater on a copper plate, dried at 80 °C for 10 minutes to remove the solvent and form a coated film having tackiness with a thickness of 50 μm. The copper plate

was introduced into a photoirradiation device in which a 2 kW high pressure mercury lamp was arranged, and irradiation was effected at an average luminosity of 90 $mW/cm^2$ (at 365 nm) for one second. The coated film was cured to became non-tacky. Then, heating curing was effected at 150 $^oC$ for one hour. The cured coated film exhibited tough and good adhesivenes (checker tape peel-off test: 100/100). The electrical characteristics of the coated film were volume resistivity of 2 x $10^{16}$ Ω•cm (25 $^oC$), 5 x $10^{12}$ Ω•cm (160 $^oC$); dielectric constant (50 Hz) of 4.1 (25 $^oC$) and 5.1 (160 $^oC$); and dielectric loss tangent of 0.5 % (25 $^oC$), 1.6 % (160 $^oC$), thus exhibiting excellent electrical insulating characteristics even at high temperature.

Example 2

An epoxy resin, Epikote 828 (trade name, produced by Yuka-Shell Epoxy Co., bisphenol A type epoxy resin, average molecular weight: 380, epoxy equivalent: 190) (500 parts) was allowed to react with 170 parts of methacrylic acid in the presence of 10 parts of trisacetylacetonatoaluminum, 4 parts of cobalt (III) acetylacetonate and 2.7 parts of p-methoxyphenol at 115 $^oC$ for 12 hours. The reaction mixture was diluted with 500 parts of toluene, washed with 3000 parts of water to remove residual methacrylic acid to separate the organic layer, followed by removal of toluene under reduced pressure to obtain a partially methacrylated epoxy resin (nonvolatiles: 97 %, epoxy equivalent: 490, free acid: 0.07 meq/g, epoxy group/methacryloyl group: 1/1). A curable resin composition was prepared by formulating 100 parts of the partially methacrylated epoxy resin, 4 parts of (1-hyroxy-1-methylethyl)phenyl ketone, 1 part of tris(ethylacetoacetato)aluminum, 2 parts of tert-butyl-peroxytriphenylsilane, 2 parts of diphenyldiethyoxy

silane and 30 parts of 1,4-dioxane. After coating of the curable resin composition similarly as in Example 1, light was irradiated for 2 seconds, followed by heating curing at 150 °C for 30 minutes and at 200 °C for 30 minutes. The cured coated film was found to have excellent electrical characteristics even at high temperature: volume resistivity: $3 \times 10^{16}$ Ω·cm (25 °C), $4 \times 10^{13}$ Ω·cm (200 °C); dielectric constant (50 Hz): 3.7 (25 °C), 4.3 (200 °C); dielectric loss tangent: 0.5 % (25 °C), 2.5 % (200 °C).

Comparative example 1

An epoxy resin, Epikote 828 (trade name, produced by Yuka-Shell Epoxy Co., bisphenol A type epoxy resin, average molecular weight: 380, epoxy equivalent: 190) (500 parts) was allowed to react with 142 parts of acrylic acid in the presence of 3 parts of choline chloride and 2.6 parts of p-methoxyphenol at 110 °C for 5 hours. The reaction mixture was diluted with 500 parts of toluene, washed with 3000 parts of water to separate the organic layer, followed by removal of toluene under reduced pressure to obtain a partially acrylated epoxy resin (nonvolatiles: 95 %, epoxy equivalent: 970, free acid: 0.00 meq/g, epoxy group/acryloyl group: 1/3). A curable resin composition was prepared by formulating 100 parts of the partially acrylated epoxy resin, 4 parts of (1-hyroxy-1-methylethyl)phenyl ketone, 15 parts of hexahydrophthalic anhydride, 1 part of dimethylbenzylamine and 30 parts of 1,4-dioxane. The curable resin composition was cured under the same conditions as in Example 1. The cured coated film was found to have electrical characteristics which were markedly lowered at 100 °C or higher: volume resistivity: $3 \times 10^{15}$ Ω·cm (25 °C), $1.2 \times 10^{12}$ Ω·cm (100 °C); dielectric constant (50 Hz): 4.3 (25 °C), 6.3 (100 °C); dielectric loss tangent

(50 Hz): 1.7 % (25 °C), 9.6 % (100 °C).

Example 3

A curable resin composition was prepared by formulating 100 parts of a partially acrylated epoxy resin (epoxy equivalent: 1550, free acid: 0.00 meq/g, epoxy group/ acryloyl group: 1/3, melting point: 50 to 60 °C) obtained by allowing 150 parts of an epoxy resin, Epikote 828 (trade name, produced by Yuka-Shell Epoxy Co., bisphenol A type epoxy resin, average molecular weight: 380, epoxy equivalent: 190) and 350 parts of an epoxy resin, Epikote 1001 (trade name, produced by Yuka-Shell Epoxy Co., bisphenol A type epoxy resin, average molecular weight: 980, epoxy equivalent: 480) to react with 82 parts of acrylic acid in the presence of 14 parts of trisacetylacetonatoaluminum and 2.5 parts of p-methoxyphenol at 110 °C for 12 hours, 2 parts of benzyldimethyl ketal, 2 parts of benzophenone, 1 part of tris(ethylacetoacetato)-aluminum, 3 parts of diphenyldiethoxy silane and 50 parts of 1,4-dioxane. The curable resin composition was applied uniformly on a copper-laminated plate, dried at 80 °C for 10 minutes to remove the solvent and form a non-tacky coated film with a thickness of 40 µm. With a nega mask contacted on this coated film, photoirradiation was effected similarly as in Example 1 for 3 seconds. After removal of the nega mask, the coated film was developed with a solvent mixture of 1,1,1-trichloroethane and 2-ethoxyethanol (95:5) to obtain an imagewise coated film corresponding to the nega mask. Subsequently, heating curing was effected at 150 °C for one hour to obtain a coated film which was excellent in adhesiveness, electrical characteristics and soldering heat resistance, etc., with the checker peel-off test being 100/100; electrical characteristics of volume resistivity: 3 x $10^{16}$ Ω·cm (25 °C), dielectric constant (50 Hz): 4.1 (25

°C) and dielectric loss tangent (50 Hz): 0.5 % (25 °C). Also, after, dipped in a soldering bath at 260 °C for one minute, no change was observed at all in appearance, adhesiveness, etc. of the coated film.

Example 4

A curable resin composition was prepared by formulating 150 parts of a partially acrylated epoxy resin (nonvolatiles: 67 %, epoxy equivalent: 1790, free acid: 0.00 meq) obtained by carrying out the reaction between 500 parts of an epoxy resin, Epikote 1001 (trade name, produced by Yuka-Shell Epoxy Co., bisphenol A type epoxy resin, average molecular weight: 980, epoxy equivalent: 480) and 53 parts of methacrylic acid dissolved in 300 parts of 1,4-dioxane in the presence of 0.1 part of triphenylphosphine and 2.5 parts of p-methoxyphenol at 120 °C for 6 hours, 4 parts of benzyldimethyl ketal, 1 part of trissalicylaldehydatoaluminum and 4 parts of diphenyldiethoxy silane. Similarly as in Example 3, photoirradiation and development were conducted to obtain an imagewise coated film corresponding to the nega mask. Subsequently, heating curing was effected at 150 °C for one hour to give a coated film excellent in adhesiveness, electrical characteristics, solder heat resistance, etc.

Example 5

A partially acrylated epoxy resin (epoxy group/acryloyl group=1/3) was synthesized by allowing 750 parts of an epoxy resin, Epikote 834 (trade name, produced by Yuka-Shell Epoxy Co., bisphenol A type epoxy resin, average molecular weight: 470, epoxy equivalent: 230) to react with 160 parts of acrylic acid in the presence of 18 parts of trisacetylacetonatoaluminum and 3 parts of p-methoxyphenol at 110 °C for 12 hours. A curable resin

composition of this invention was prepared by mixing 70 parts of the partially acrylated epoxy resin, 15 parts of 1,6-hexanediol diacrylate, 15 parts of 2-hydroxy-3-phenoxypropyl acrylate, 4 parts of (1-hydroxy-1-methylethyl)phenyl ketone, 1 part of tris(ethylaceto-acetato)aluminum, 3 parts of diphenyldimethoxy silane, 2 parts of colloidal silica, 20 parts of silica powder, 0.6 parts of Phthalocyanine Green as coloring pigment and 0.5 parts of silicone oil as defoaming agent, and kneading the mixture on rolls. The resin composition had a viscosity of 130 poise at 25 °C. After the resin composition was applied by a screen of 150 mesh on the entire surface of an IPC-B-25 test circuit substrate, exposure was effected through a nega mask thereon by means of a high pressure mercury lamp as parallel rays at a luminosity of 5 $mW/cm^2$ for 40 seconds. Subsequently, development was carried out for 30 seconds by use of 1,1,1-trichloroethane, followed by heating curing at 150 °C for one hour. Accurate coated film corresponding to the nega mask was obtained. In the checker tape peel-off test of the coated film, no peel-off of the coated film was observed. The coated film was found to have a pencil hardness of 4H. Even after the coated film surface was dipped in a soldering bath of 260 °C for 30 seconds, no change in appearance or adhesiveness was observed at all. Electric resistance according to IPC-SM-840 method 2.5.23 was found to be $2 \times 10^{14}$ Ω under normal conditions. Electrical resistance after maintained in an atmosphere of 50 °C and a relative humidity of 95 % for 7 days was $8 \times 10^{12}$ Ω, thus exhibiting high insulating property.

Example 6

A partially acrylated epoxy resin (epoxy group/acryloyl group=1/3) was synthesized by allowing 700 parts of an

epoxy resin, Epikote 1001 (trade name, produced by Yuka-Shell Epoxy Co., bisphenol A type epoxy resin, average molecular weight: 980, epoxy equivalent: 480) and 300 parts of an epoxy resin, Epikote 828 (trade name, produced by Yuka-Shell Epoxy Co., bisphenol A type epoxy resin, average molecular weight: 380, epoxy equivalent: 190) to react with 160 parts of acrylic acid in the presence of 23 parts of trisacetylacetonatoaluminum and 4 parts of p-methoxyphenol at 110 °C for 12 hours. A curable resin composition of this invention was prepared by blending 60 parts of this acrylated epoxy resin, 30 parts of the partially acrylated epoxy resin synthesized in Example 5, 10 parts of dipenthaerythritol hexaacrylate, 5 parts of benzyldimethyl ketal, 1 part of trisacetylacetonatoaluminum, 4 parts of tert-butylperoxytriphenyl silane, 40 parts of 2-ethoxyethanol, 2 parts of colloidal silica, 20 parts of silica powder, 0.6 parts of Phthalocyanine Green and 0.5 parts of silicone oil, and kneading the mixture on rolls. The resin composition was applied by a screen of 150 mesh on the entire surface of the same circuit plate as employed in Example 5, and then dried at 80 °C for 15 minutes. Next, with a nega mask contacted on the coating, exposure was effected thereon by means of a high pressure mercury lamp at a luminosity of 100 $mW/cm^2$ for 5 seconds. After exposure, development was carried out with the use of a solvent mixture of 1,1,1-trichloroethane and ethyleneglycoal monobutyl ether (volume ratio=95:5) for one minute, followed by heating curing at 150 °C for one hour. Accurate coated film corresponding to the nega mask was obtained. In the checker tape peel-off test of the coated film, no peel-off of the coated film was observed. The coated film was found to have a pencil hardness of 4H. Even after the coated film surface was dipped in a soldering bath of 260 °C for 30 seconds, no change in appearance or adhesiveness was observed at all. Electrical resistance

was found to be $7 \times 10^{13}$ Ω under normal conditions. Electrical resistance after maintained in an atmosphere of 50 °C and a relative humidity of 95 % for 7 days was $9 \times 10^{12}$ Ω, thus exhibiting high insulating property.

Example 7

A curable resin composition of this invention was prepared by kneading on rolls 75 parts of a partially acrylated epoxy resin (epoxy group/acryloyl group=1/1) obtained by allowing 1000 parts of an epoxy resin, Epikote 828 (trade name, produced by Yuka-Shell Epoxy Co., bisphenol A type epoxy resin, average molecular weight: 380, epoxy equivalent: 190) to react with 190 parts of acrylic acid in the presence of 24 parts of trisacetylacetonatoaluminum and 4 parts of p-methoxyphenol at 110 °C for 10 hours, 25 parts of dipropylene glycol dimethacrylate, 4 parts of (1-hydroxy-1-methylethyl)phenylketone, 1 part of tris(ethylacetoacetato)-aluminum, 3 parts of diphenyldimethoxysilane, 2 parts of colloidal silica, 20 parts of silica powder, 0.6 part of Phthalocyanine Green and 0.5 parts of silicone oil. After the resin composition was applied imagewisely by use of a screen of 150 mesh on the same circuit plate as employed in Example 5, exposure was effected thereon for five minutes by use of the same lamp as used in Example 6. Then, heating curing was effected at 150 °C for one hour. When the same experiments as in Example 5 were conducted, good adhesiveness and solder heat resistance were exhibited. The pencil hardness was 4H, the electrical resistance under normal conditions was $8 \times 10^{13}$ Ω and after moisture absorption was $7 \times 10^{12}$ Ω.

Example 8

A curable resin composition of this invention was

prepared by mixing 70 parts of the partially acrylated epoxy resin synthesized in Example 6, 20 parts of trimethylolpropane, 5 parts of benzyldimethyl ketal, 1 part of trisacetylacetonatoaluminum, 4 parts of tert-butylperoxytriphenyl silane, 10 parts of methyl methacrylatestyrene (2:1) copolymer, 2 parts of colloidal silica, 10 parts of silica powder, 0.6 parts of Phthalocyanine Green, 0.3 parts of silicone oil and 150 parts of methylethyl ketone. The resin composition was applied on a 25 µm thick polyethyleneterephthalate film and dried at 70 °C for one hour to prepare a photosensitive film having a resin layer with a thickness of 50 µm. The photosensitive film was pressure contacted on the same circuit plate as in Example 5 at 100 °C by means of rolls. Next, a nega mask was closely contacted on the photosensitive film and subjected to exposure by use of the same lamp as in Example 6 for 5 seconds. Then, the nega mask and the polyethyleneterephthalate film were peeled off, and development was carried out with the use of the same developing solvent as in Example 6 for 2 minutes, followed by heating curing at 150 °C for one hour. Accurate coated film corresponding to the nega mask was obtained. When the same experiments as in Example 5 were conducted, good adhesiveness and solder heat resistance were exhibited. The pencil hardness was 4H, the electrical resistance under normal conditions was $8 \times 10^{13}$ Ω and after moisture absorption was $7 \times 10^{12}$ Ω.

Comparative example 2

In place of the partially acrylated epoxy resin in Example 5, a diacrylate resin was used, which was obtained by allowing 750 parts of Epikote 834 (trade name, produced by Yuka-Shell Epoxy Co., bisphenol A type epoxy resin, average molecular weight: 470) to react with 215 parts of acrylic acid in the presence of 3.5 parts of

dimethylbenzylamine and 3 parts of p-methoxyphenol at 110 °C for 4 hours. That is, 70 parts of said diacrylate resin, 15 parts of 1,6-hexanediol diacrylate, 15 parts of 2-hydroxy-3-phenoxypropylacrylate, 4 parts of (1-hydroxy-1-methylethyl)phenylketone, 2 parts of colloidal silica, 20 parts of silica powder, 0.6 parts of Phthalocyanine Green and 0.5 parts of silicone oil were mixed to obtain a curable resin composition. By use of this resin comosition, coating, exposure, development and heating curing were performed similarly as in Example 5 to form a coated film. When the same tests as in Example 5 were conducted, adhesiveness was good and the pencil hardness was 4H, but blisters were found to be formed only partially at the upper portion of the circuit on the solder dipped surface. The electrical resistance was $5 \times 10^{13}$ Ω under normal conditions, which was lowered to $8 \times 10^{11}$ Ω after moisture absorption.

Comparative example 3

Except for using, in place of the partially acrylated epoxy resin in Example 5, a mixture (epoxy group/acryloyl group=1/3) of 79 parts of the diacrylate resin synthesized in Comparative example 2 and 21 parts of Epikote 834 (trade name, produced by YukaShell Epoxy Co., bisphenol A type epoxy resin, average molecular weight: 470, epoxy equivalent: 230), a resin composition was prepared according to the same formulation as in Example 5. When coating, exposure, development and heating curing were performed similarly as in Example 5, blisters were formed partially on the circuit during heating curing.

As described in detail above, the curable resin composition of this invention can be cured by photoirradiation and heating, and the cured product

obtained has excellent electrical characteristics, adhesiveness, humidity resistance and solder heat resistance, and therefore it can be expected to be useful for electrical insulating materials, paints, materials for solder resist, etc., with its industrial value being very great.

Claims:

1. A curable resin composition comprising:

(a) at least one of partially acrylated and methacrylated epoxy resins;

(b) a sensitizer which can initiate the polymerization of at least one of acryloyl group or methacryloyl group by photoirradiation;
and

(c) a curing catalyst comprising an organic metal compound and an organic silicon compound.

2. The curable resin composition according to Claim 1, wherein said partially acrylated and methacrylated epoxy resin in component (a) is a resin obtained by the reaction of an epoxy resin with at least one of acrylic acid and methacrylic acid at an equivalent ratio (latter/former) of 0.1 to 0.9 in the presence of an organic metal compound or an organic phosphorus compound.

3. The curable resin composition according to Claim 2, wherein the organic metal compound used for the preparation of the resin in component (a) is selected from compounds comprising at least one metal selected from the group consisting of aluminum, gallium, tin, zirconium, zinc, copper, iron, nickel, cobalt, manganese, chromium, vanadium, platinum, molybdenum and palladium.

4. The curable resin composition according to Claim 3, wherein said organic metal compound is an organic aluminum compound.

5. The curable resin composition according to Claim 4, wherein the amount of said organic aluminum compound employed is 5 % by weight or less based on component (a).

6. The curable resin composition according to Claim 2, wherein said organic phosphorus compound is a tertiary phosphine.

7. The curable resin composition according to Claim 2, wherein the amount of said organic phosphorus compound employed is 0.5 % by weight or less based on component (a).

8. The curable resin composition according to Claim 1, wherein said organic metal compound in component (c) is an organic aluminum compound.

9. The curable resin composition according to Claim 8, wherein the amount of said organic aluminum compound in component (c) is 0.1 to 5 % by weight based on the total amount of components (a) to (c).

10. The curable resin composition according to Claim 1, wherein said organic silicon compound in component (c) is a compound capable of forming silanol group by photoirradiation.

11. The curable resin composition according to Claim 10, wherein the compound capable of forming silanol group by photoirradiation is a compound having at least one of an alkoxysilyl group, an aryloxysilyl group, a peroxysilyl group and an α-ketosilyl group.

12. The curable resin composition according to Claim 10, wherein the amount of said organic silicon compound in component (c) is 0.1 to 10 % by weight based on the total amount of components (a) to (c).

13. The curable resin composition according to Claim 1, wherein said curable resin composition further comprises

(d) a compound having at least one group selected from the group consisting of an acryloyl group, a methacryloyl group and an epoxy group, with proviso that component (a) is excluded.

14. The curable resin composition according to Claim 13, wherein the ratio of component (a) to component (d) is within the range of from 40 : 60 to 95 : 5, and the ratios of the respective components to the total amount of components (a) to (d) are 80 to 99 % by weight for the total amount of components (a) and (b), 0.5 to 10 % by weight for component (b) and 0.5 to 10 % by weight for component (c).